# EUROPEAN PATENT APPLICATION

(11) **EP 4 730 038 A1**
(43) Date of publication of application: **22.04.2026**
(21) Application number: 24838829.0
(22) Date of filing: 10.07.2024
(51) Int. Cl.: G03F 7/26

(54) **FLEXOGRAPHIC PRINTING PLATE WASHING APPARATUS MULTI-AXIS SYSTEM**

(30) Priority: 11.07.2023 CN 202310843554
(71) Applicant: Kcw Printech International Limited, Kowloon, Hong Kong (HK)
(72) Inventor: TING, So Yung Warren, Shenzhen, Guangdong 518100 (CN); LIU, Houlai, Shenzhen, Guangdong 518100 (CN)
(74) Representative: Metida
(86) International application number: PCT/CN2024/104721
(87) International publication number: WO 2025/011577

(57) **Abstract**

A flexographic printing plate washing apparatus multi-axis system, the plate washing equipment includes a skeleton structure for supporting the multi-axis system. The multi-axis system includes: a plate transmission part (1), installed on the skeleton structure and configured for driving a plate to rotate; and a material transmission part (2), installed on the skeleton structure and configured for driving a plate washing material to rotate. The plate transmission part (1) and the material transmission part (2) cooperate synergistically during a transmission of the plate and the plate washing material, and enable a side surface of the plate washing material abuts against a surface of the plate and adhere to a black film on the surface of the plate.

## Description

### TECHNICAL FIELD

The present disclosure relates to the field of printing, and in particular to a flexographic printing plate washing apparatus multi-axis system.

### BACKGROUND

Flexographic printing is a method of printing using flexographic printing plates to transfer ink through anilox rollers, which is a type of relief printing process, referred to as flexo for short.

The image-text part of the flexographic printing plate is raised. During printing, the anilox roller uniformly coats a certain thickness of ink layer on the image-text part of the plate, and then under the pressure of the impression cylinder, the ink layer of the image-text part is transferred to the surface of the substrate to form clear image-text.

Most flexographic printing plates are made of prefabricated solid photosensitive resin. The plate making of solid photosensitive resin plates has many advantages such as large tolerance, uniform thickness, ability to accommodate very fine highlight levels, smaller shrinkage than rubber plates and liquid plates, and high printing resistance, which greatly improves the precision and quality of flexographic printing compared with traditional rubber plates. At present, the maximum resolution of solid photosensitive resin plates has exceeded 350 lines, the dot reproduction capability can reach 1% to 95%, and the plate flatness is ±0.013mm.

Flexographic printing plates are generally exposed to ultraviolet light. The transparent parts transmit ultraviolet light, and the initiator in the photosensitive elastomer decomposes into free radicals, which initiate the crosslinking monomer reaction and cure; the areas not transmitting ultraviolet light cannot undergo crosslinking reaction. Using the difference in their solubility in the developer, the relief image containing text and patterns is obtained by rinsing and developing. After development, the plate needs to be dried, desensitized, and post-exposed to ensure complete polymerization of the photosensitive layer to form a prepared flexographic printing plate. Afterwards, the prepared flexographic printing plate is fixed on the roller of the flexographic printing machine, and printing can be prepared.

However, in the current flexographic printing plate making process, the plate washing process needs to use developer to clean the black film on the plate. The black film is affected by temperature, and the optimal temperature for the black film to fall off is between 27° and 42°. During the cleaning process, the black film is greatly affected by the temperature of the water flow, and the water flow will take away a lot of temperature, resulting in inconsistent plate washing effects. Moreover, the components of the developer cleaning method will at least cause harm to the environment, and its smell will irritate the staff in the cleaning space. In response to this, the applicant considers whether to adopt a non-liquid plate washing method for plate washing, but there are many problems to be solved in the non-liquid plate washing process, such as the flatness of the plate washing material, which will lead to inconsistent plate washing effects.

### SUMMARY

In order to minimize the impact of the flatness of the plate washing material on the plate washing effect, the present disclosure provides a flexographic printing plate washing apparatus multi-axis system.

The flexographic printing plate washing apparatus multi-axis system provided by the present disclosure adopts the following technical scheme:
A flexographic printing plate washing apparatus multi-axis system, the multi-axis system is arranged on a skeleton structure for support inside the plate washing equipment, including:
a plate transmission part, the plate transmission part is installed on the skeleton structure, and the plate transmission part is at least used to drive the plate to move and make the plate generate rotational displacement;
a material transmission part, the material transmission part is installed on the skeleton structure, and the material transmission part is at least used to drive the plate washing material to move and make the plate washing material generate rotational displacement;
the plate transmission part and the material transmission part cooperate synergistically during the material transmission process, so that the side surface of the plate washing material abuts against the surface of the plate, thereby adhering to the black film on the surface of the plate.

By adopting the above technical scheme, the plate is driven by the plate transmission part, and the plate washing material is driven by the material transmission part. When the plate and the plate washing material overlap, the plate washing material can adhere to the black film on the plate, thereby achieving the purpose of non-liquid plate washing.

Preferably, a shaft coordination assembly is further arranged on the skeleton structure, and the shaft coordination assembly is at least used for winding the plate washing material.

By adopting the above technical scheme, the shaft coordination assembly can push the plate washing material, so that the plate washing material can be pressed against the plate, so that the plate washing material can have a good and elastic tension effect, flatten the plate washing material, which is beneficial to the transmission of the plate washing material and the good cleaning effect between the plate washing material and the plate.

Preferably, the shaft coordination assembly includes a tensioning member, and the tensioning member is at least used for tensioning the plate washing material during use.

Preferably, the shaft coordination assembly further includes a cooperative transmission member, and the cooperative transmission member is at least used for cooperatively transmitting the plate washing material during use.

Preferably, the shaft coordination assembly further includes a self-suspending member, and the self-suspending member is at least used for flattening the plate washing material or the plate during use.

By adopting the above technical scheme, the tensioning member can tension the plate washing material, so that the loose plate washing material can be flattened during the plate washing process; the cooperative transmission member can correct the possible local uneven parts of the plate washing material by increasing the transmission stroke of the plate washing material; the self-suspending member can dynamically adjust during the operation of the plate washing material through the gravity effect in the vertical direction. The synergistic effect of the three can correct the locally uneven plate washing material to be relatively flat, and can also keep the already flat plate washing material flat, thereby ensuring the plate washing effect.

Preferably, the outer surface of the self-suspending member is made of a soft material.

By adopting the above technical scheme, the friction force of the self-suspending member is relatively improved, so that the plate washing material can tend to be flat after the synchronous dynamic adjustment of the self-suspending member, and the shape of the already flat plate washing material can be maintained as much as possible.

Preferably, the tensioning member includes a driving part, a tensioning part and a clamping and winding part. The driving part is assembled with the tensioning part. The driving part is used to drive the tensioning part to displace in the horizontal direction so that the plate washing material wound on it can abut against the plate transmitted by the plate transmission part. The clamping and winding part is used to maximize the contact area between the plate washing material and the tensioning part, at least for flattening the plate washing material before plate washing.

By adopting the above technical scheme, the driving part drives the tensioning part to displace in the horizontal direction so that the plate washing material wound on it can abut against the plate transmitted by the plate transmission part. The tensioning part is used for active tensioning during the transmission of the plate washing material to flatten the plate washing material. The clamping and winding part can maximize the contact area between the plate washing material and the tensioning part, so that the plate washing material before plate washing has a good pre-treatment; the third clamping transmission roller and the fifth clamping transmission roller are arranged on the same side, so that the surface of the plate can pass through the surface of the fourth heating transmission roller to a large extent, improving the adhesion of the plate and maintaining a certain temperature; the exteriors of the third clamping transmission roller, the fourth heating transmission roller and the fifth clamping transmission roller are all covered with soft materials, which improves the friction force of the plate transmission part, so that the plate can be as close to the plate transmission part as possible during the clamping, rotating and transmitting process, and the plate continuity during the plate washing process is improved to enhance the plate washing effect; in other cases, when used in the printing process with high precision and stability requirements, the exteriors of the third clamping transmission roller, the fourth heating transmission roller and the fifth clamping transmission roller are not covered with soft materials respectively. The above scheme can be adaptively adjusted according to requirements, expanding the scope of application.

Preferably, the material transmission part has an outer surface dimension expansion structure.

By adopting the above technical scheme, the material transmission part can expand the surface dimension, facilitate the disassembly and assembly of the plate washing material, and also enable the plate washing material itself to have a good elastic tension effect.

Preferably, the plate transmission part has a clamping structure, and the clamping structure can be at least used for clamping the plate.

By adopting the above technical scheme, the plate is stably installed on the plate transmission part by using the clamping structure, so that the plate can stably dock and press against the plate washing material, effectively enhancing the effect of the plate washing material in cleaning the black film on the surface of the plate.Preferably
In an embodiment of the present disclosure, the outer surface of the plate transmission part is made of a soft material.

By adopting the above technical scheme, the friction force of the plate transmission part is relatively improved, so that the plate can be as close to the plate transmission part as possible during the clamping, rotating and transmitting process, and the plate continuity during the plate washing process is improved to enhance the plate washing effect.

In summary, the present disclosure includes at least one of the following beneficial technical effects:
1. increase the stroke of the plate washing material, so that the plate washing material is gradually corrected during the transmission process.
2. increase the contact area between the plate washing material and the roller structure, and improve the flatness of the plate washing material before plate washing.
3. raise and maintain the local temperature of the plate washing material, slow down the temperature change, and the plate washing effect is better and more stable.
4. the overall tension of the plate washing material is dynamically adjusted, which can be actively and cooperatively adjusted, so that the plate washing material can elastically correct its surface flatness.

### BRIEF DESCRIPTION OF DRAWINGS

FIG. 1 is a schematic view of the overall structure in the embodiment of the present disclosure.
FIG. 2 is a schematic view of the distribution of the shaft system structure with part of the skeleton structure removed in the embodiment of the present disclosure.
FIG. 3 is an enlarged view of the portion A in FIG. 2.
FIG. 4 is a schematic view of the arrangement of the shaft system and the transmission direction of the plate washing material in the embodiment of the present disclosure.
FIG. 5 is a schematic view of the internal shaft structure of the water cooling assembly in the embodiment of the present disclosure.
FIG. 6 is a schematic view of the internal shaft structure of the passive conveying roller or the active conveying roller in the embodiment of the present disclosure.

### Explanation of reference numerals:

1. Plate transmission part;
11. First active rotating roller; 111. Outer roller body; 112. Inner roller body;
12. Water cooling assembly; 121. Sleeved roller body; 122. Sealed inner cavity; 123. Water circulation pipeline; 13. Clamping assembly; 131. Clamping part; 1311. Clamping groove; 1312. Clamping strip; 1313. Concave-convex surface; 1314. Frosted surface;
132. Driving part; 1321. Driving handle; 1322. Metal plate; 1323. First fixed shaft; 1324. Second fixed shaft; 1325. Rotating member; 1326. Swing shaft; 1327. Elastic member; 1328. Supporting block;

2. Material transmission part; 21. Passive conveying roller; 22. Active conveying roller; 23. Strip-shaped space; 24. Threaded rotating shaft; 25. Arc-shaped piece; 26. Reset member; 27. Insert strip;
3. Shaft coordination assembly;
   31. Tensioning member; 311. Synchronous commutator; 312. Slideway; 313. Displacement seat; 314. Lead screw driving module; 315. Third clamping transmission roller; 316. Fourth heating transmission roller; 317. Fifth clamping transmission roller; 32. Cooperative transmission member; 321. First cooperative transmission roller; 322. Second cooperative transmission roller; 323. Sixth cooperative transmission roller; 324. Seventh cooperative transmission roller;
   33. Self-suspending member; 331. Eighth self-suspending sliding roller; 332. Ninth self-suspending sliding roller; 333. Tenth self-suspending sliding roller; 334. First sliding groove;
   335. Second sliding groove; 336. Third sliding groove.

### DESCRIPTION OF EMBODIMENTS

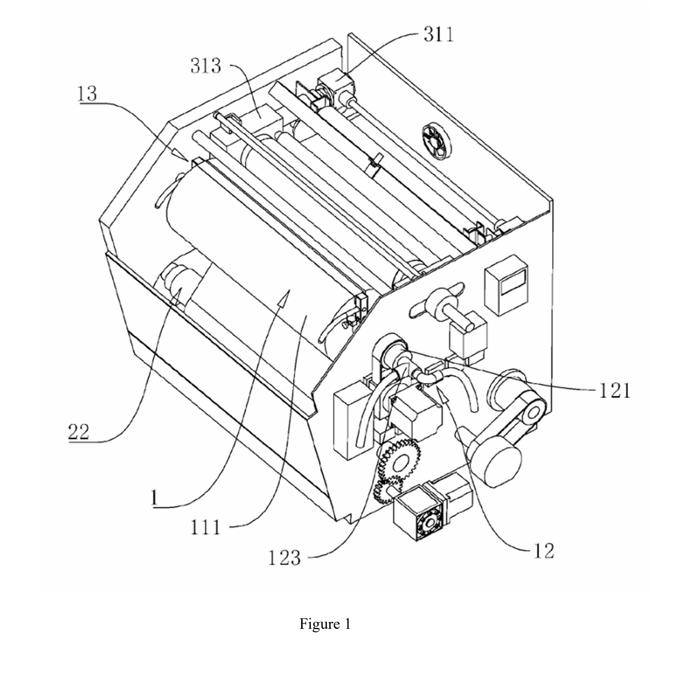

The present disclosure will be further described in detail below with reference to FIGS. 1-6. The embodiment of the present disclosure discloses a flexographic printing plate washing apparatus multi-axis system.

Referring to FIG. 1, a flexographic printing plate washing apparatus multi-axis system includes three parts: one is a plate transmission part 1 for driving the plate to move and making the plate generate rotational displacement; the second is a material transmission part 2 for driving the plate washing material to move and making the plate washing material generate rotational displacement; the third is a shaft coordination assembly 3 for winding the plate washing material.

In this embodiment, both the plate transmission part 1 and the material transmission part 2 are installed on the skeleton structure. The plate transmission part 1 and the material transmission part 2 cooperate synergistically during the material transmission process, so that the side surface of the plate washing material abuts against the surface of the plate, thereby adhering to the black film on the surface of the plate.

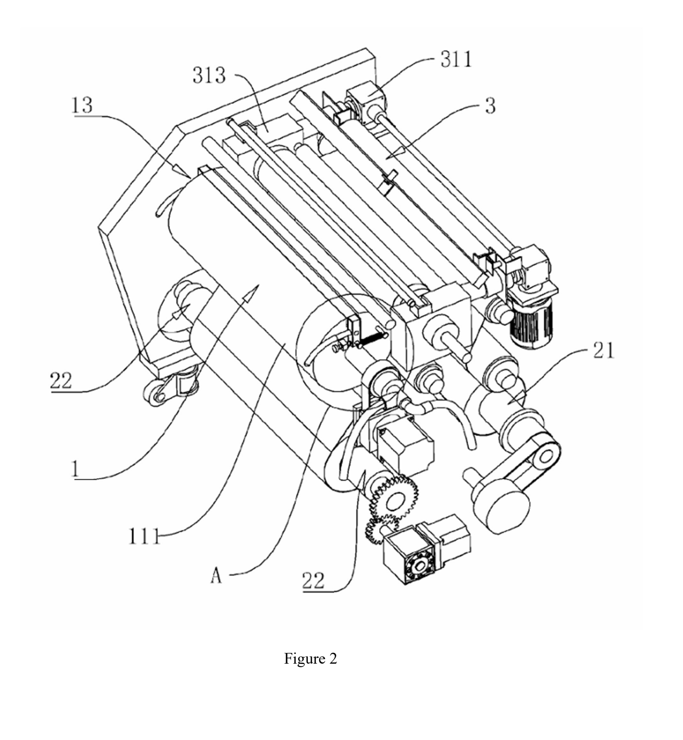

Specifically, referring to FIGS. 1 and 2, in this embodiment, both sides of the plate transmission part 1 are provided with roller shaft supports. The plate transmission part 1 includes a first active rotating roller 11, which is installed between the skeleton structures. The first active rotating roller 11 is equipped with a corresponding power source. In this embodiment, the power source adopts a motor, which can be a servo motor, a stepping motor, etc. with forward and reverse rotation capabilities. A reducer is also used in conjunction with the motor here. The assembly of the motor and the reducer is installed on the side wall of one side of the skeleton structure away from the first active rotating roller 11.

In addition, in this embodiment, referring to FIG. 2, the first active rotating roller 11 includes an outer roller body 111 and an inner roller body 112. The outer roller body 111 is assembled with the inner roller body 112, and the outer roller body 111 and the inner roller body 112 can rotate synchronously.

Moreover, in this embodiment, the outer roller body 111 is made of a material with relatively large friction force, such as soft materials like foamed silica gel and rubber, while the inner roller body 112 is a hollow metal pipe structure. In this embodiment, the inner roller body 112 is made of a material with good thermal conductivity, such as copper.

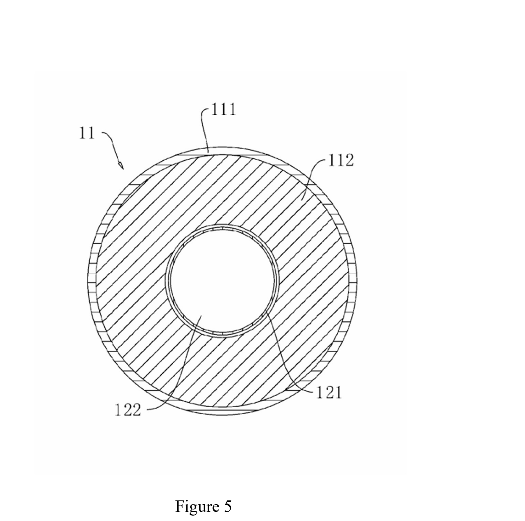

Referring to FIG. 5, rolling bearing structures are assembled on the roller shaft supports on both sides of the plate transmission part 1. The inner roller body 112 is fixedly connected to the outer layer of the rolling bearing structure, and the output end of the reducer is assembled with the outer layer of the rolling bearing structure on one side through a transmission structure composed of a belt, a pulley, etc., so that the power source motor here can drive the rolling bearing structure assembled with it to rotate after being transmitted by the reducer, and then drive the inner roller body 112 and the outer roller body 111 to rotate synchronously.

In this embodiment, referring to FIG. 5, a water-cooling assembly 12 is arranged in the plate transmission part 1.

Specifically, referring to FIG. 5, the water-cooling assembly 12 includes a sleeved roller body 121, which is arranged at the hollow inner cavity of the inner roller body 112. The sleeved roller body 121 is fixedly connected to the inner layer of the rolling bearing structure. The sleeved roller body 121 is also a hollow metal pipe structure. In this embodiment, the sleeved roller body 121 is made of a material with good thermal conductivity, such as copper. The outer wall of the sleeved roller body 121 abuts against the inner wall of the inner roller body 112. Lubricating oil is hermetically coated in the gap between the sleeved roller body 121 and the inner roller body 112. In addition, the actual rotating speed of the entire plate transmission part during use is relatively low, generally in the range of one to two revolutions per minute. Combined with the rolling connection between the inner layer and the outer layer of the rolling bearing structure, although the sleeved roller body 121 is in a certain abutment with the inner roller body 112, the inner roller body 112 will not drive the sleeved roller body 121 to rotate during rotation.

In addition, referring to FIG. 5, in this embodiment, the sleeved roller body 121 has a sealed inner cavity 122. The water-cooling assembly 12 further includes a water circulation pipeline 123 connected to the inner cavity of the sleeved roller body 121 and an industrial water chiller. The water circulation pipeline 123 is assembled and connected to the industrial water chiller. The industrial water chiller can circulate liquid water into the sleeved roller body 121 through the water circulation pipeline 123 to form a water circulation to take away heat, so that the water-cooling assembly 12 can at least adjust the temperature of the surface of the plate transmission part 1.

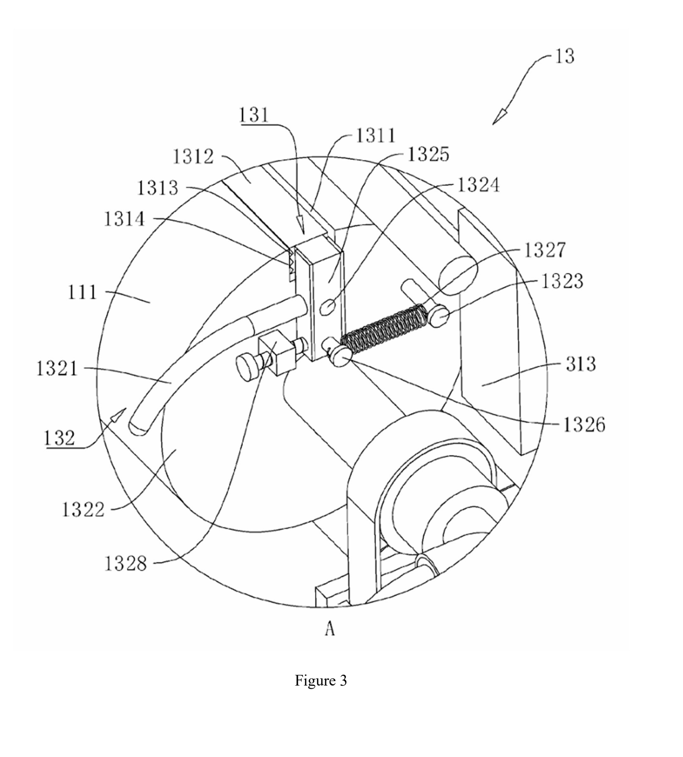

In order to clamp the plate, a clamping structure 13 is provided on the plate transmission part 1. Referring to FIGS. 2 and 3, in this embodiment, the clamping structure 13 includes a clamping part 131 for clamping the plate and a driving part 132 for driving the clamping part 131 to act. The clamping part 131 is arranged on the surface of the outer roller body 111. The driving part 132 is arranged on the side of the inner roller body 112. The output end of the driving part 132 is assembled with the clamping part 131 so as to drive the clamping part 131 to perform clamping action, so that the clamping part 131 can clamp the plate.

In this embodiment, the clamping part 131 includes a clamping groove 1311 arranged on the surface of the outer roller body 111.

Referring to FIGS. 2 and 3, specifically, the clamping groove 1311 is a metal channel with a two-dimensional "U" shape in cross-section. A clamping strip 1312 is movably arranged in the clamping groove 1311, and the clamping strip 1312 can swing in the clamping groove 1311. The driving part 132 includes a driving handle 1321, which is assembled with the clamping strip 1312. Specifically, metal plates 1322 are arranged on the side walls of both sides of the plate transmission part 1. A first fixed shaft 1323 and a second fixed shaft 1324 are installed on each metal plate 1322. A rotating member 1325 is also sleeved on the second fixed shaft 1324. The rotating member 1325 can be a structural body with an end part such as a metal strip or a metal block. The rotating member 1325 can rotate around the second fixed shaft 1324 as the center. The top end of the rotating member 1325 in the vertical direction is fixedly connected to the clamping strip 1312, specifically by welding. At the same time, a swing shaft 1326 extends from the bottom end of the rotating member 1325 in the vertical direction. An elastic member 1327 is pulled between the first fixed shaft 1323 and the swing shaft 1326. In this embodiment, the elastic member 1327 adopts a torsion spring. Of course, in other embodiments, it can also adopt a spring and other components, which need to have sufficient elastic capacity and reset capacity. At the same time, supporting blocks 1328 are installed on the side walls of both sides of the metal plate 1322. The supporting blocks 1328 can support the driving handle 1321. The driving handle 1321 can drive the clamping strip 1312 to swing in the clamping groove 1311. The swing center of the clamping strip 1312 is the axis of the second fixed shaft 1324. The cooperation between the clamping strip 1312 and the clamping groove 1311 can clamp the plate.

Referring to FIGS. 2 and 3, at the same time, in order to better clamp the plate, the side wall of the clamping strip 1312 is provided with a concave-convex surface 1313, and the side wall of the clamping groove 1311 is provided with a frosted surface 1314 to further improve the clamping effect.

In this embodiment, the clamping groove 1311 is specifically installed by threaded connection, which penetrates the outer roller body 111 through threaded connection and is fixedly connected to the surface of the inner roller body 112 without penetrating into the inner roller body 112. The clamping groove 1311 will pull and compress the outer roller body 111 during installation.

For the part of cleaning the plate, a material transmission part 2 is provided in this embodiment. The material transmission part 2 is installed on the skeleton. The material transmission part 2 is used to drive the plate washing material to move and make the side surface of the material abut against the surface of the plate, so that the plate washing material can absorb and clean the substances on the surface of the plate.

In this embodiment, the plate washing method adopts a non-liquid plate washing method, specifically, the unexposed and cured black film on the surface of the plate is adhered and removed by pressing and adhering. In this embodiment, after testing, the specific plate washing material used in this embodiment is a polyester non-woven fabric bundle. In addition to the characteristic of temperature resistance, the polyester non-woven fabric also has the characteristic of being difficult to shed hair. During the process of adhering and removing the black film, the fine hairs of the non-woven fabric itself will not be reversely adhered to the plate, damaging the plate. The black film on the surface of the plate is cleaned after being adhered and removed by the polyester non-woven fabric.

The material transmission part 2 includes a passive conveying roller 21 for loading the plate washing material before use and an active conveying roller 22 for loading the used plate washing material. Since the use logic of the plate washing material in this embodiment is non-high-speed operation, both the passive conveying roller 21 and the active conveying roller 22 are installed on the skeleton structure in a single-side installation manner. Correspondingly, the skeleton structure on the other side is provided with a taking and placing port to facilitate the disassembly and assembly of the plate washing material.

The active conveying roller 22 is also equipped with a corresponding power source. In this embodiment, the power source adopts a motor, which can be a servo motor, a stepping motor, etc. with forward and reverse rotation capabilities. A worm gear reducer is also used in conjunction with the motor here. The assembly of the motor and the worm gear reducer is installed on the side wall of one side of the skeleton structure away from the active conveying roller 22. The active conveying roller 22 is provided with a roller shaft support, which is installed on the skeleton structure. One end of the active conveying roller 22 away from the taking and placing port is assembled with the assembly of the motor and the worm gear reducer and drives the active conveying roller 22 to rotate through the mutual meshing of large and small gears. The size of the gear on the active conveying roller 22 is at least ten times or more than the size of the gear on the assembly of the motor and the worm gear reducer. Driven by the motor, the non-woven fabric bundle can be gradually wound and transferred from the passive conveying roller 21 to the active conveying roller 22. During the transfer process, the non-woven fabric can abut against the plate, and the plate washing purpose is achieved during the winding process.

In addition, the passive conveying roller 21 is also provided with a roller shaft support, which is also installed on the skeleton structure. One end of the passive conveying roller 21 away from the taking and placing port is assembled with a magnetic powder brake through the connection of a belt and a pulley. The magnetic powder brake can adapt to the actual use situation to perform a certain tension control on the plate washing material, so that the plate washing material can be tensioned when needed and appropriately relaxed when not needed.

Both the passive conveying roller 21 and the active conveying roller 22 on the material transmission part 2 have an outer surface dimension expansion structure.

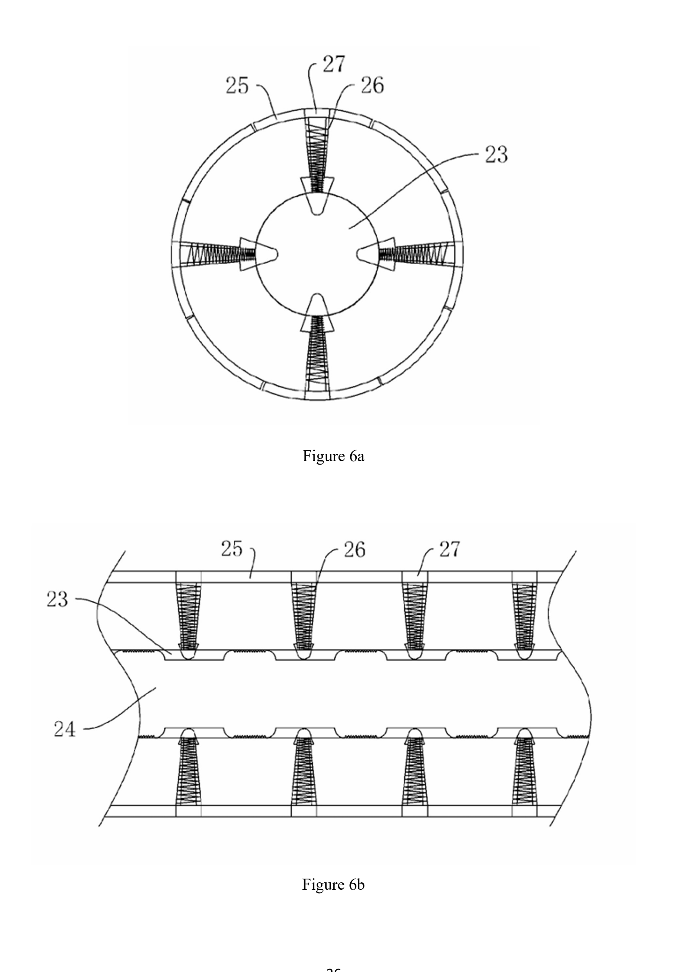

Referring to FIG. 6, in this embodiment, the specific implementation method is to open a strip-shaped space 23 in the middle of the roller body. The inner wall of the strip-shaped space 23 is provided with a threaded structure, and a threaded rotating shaft 24 is screwed into the strip-shaped space 23 from the outside of the roller body. Arc-shaped pieces 25 are movably arranged on the surfaces of the active conveying roller 22 and the passive conveying roller 21. The arc-shaped pieces 25 are correspondingly assembled and connected with the active conveying roller 22 and the passive conveying roller 21, so that the arc-shaped pieces 25 will not fall off from the active conveying roller 22 and the passive conveying roller 21.

Moreover, a reset member 26 is also abutted between the arc-shaped piece 25 and the active conveying roller 22 and the passive conveying roller 21. In this embodiment, the reset member 26 can use a reset spring, so that the arc-shaped piece 25 will be tightened on the surfaces of the active conveying roller 22 and the passive conveying roller 21 in the non-force-bearing state.

At the same time, the assembly of the arc-shaped piece 25 with the active conveying roller 22 and the passive conveying roller 21 is inserted and connected by a plurality of insert strips 27. The insert strips 27 have heads, and the insert strips 27 themselves will not come out of the strip-shaped space 23 as a whole. When the arc-shaped piece 25 is tightened on the surfaces of the active conveying roller 22 and the passive conveying roller 21, the insert strips 27 protrude into the strip-shaped space 23. When the threaded rotating shaft 24 is tightened, it will abut against the insert strips 27. After the insert strips 27 are stressed, they will drive the arc-shaped piece 25 to displace away from the surfaces of the active conveying roller 22 and the passive conveying roller 21, so that the outer surface dimension of the material transmission part 2 can be expanded. After the non-woven fabric bundle is sleeved, the non-woven fabric bundle can be stably installed on the active conveying roller 22 or the passive conveying roller 21 through this measure.

In order to better wash the plate during the transfer process of the non-woven fabric bundle from the passive conveying roller 21 to the active conveying roller 22.

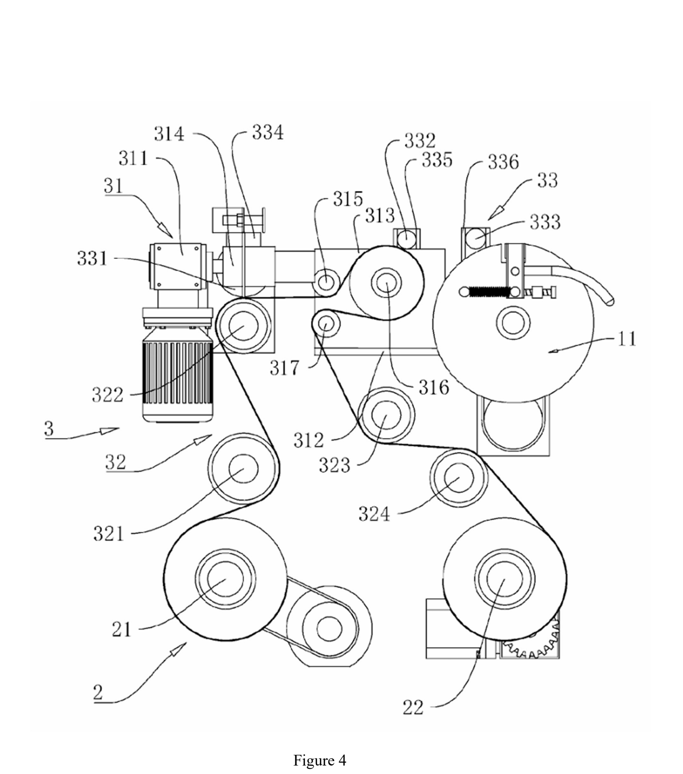

Referring to FIG. 4, in this embodiment, a shaft coordination assembly 3 is further arranged on the skeleton, and the shaft coordination assembly 3 can be at least used for winding the plate washing material.

Specifically, in this embodiment, the shaft coordination assembly 3 includes a tensioning member 31, a cooperative transmission member 32 and a self-suspending member 33.

Among them, the tensioning member 31 can be used for tensioning the plate washing material, the cooperative transmission member 32 can be used for winding the plate washing material, and the self-suspending member 33 can be used for improving the tightness between the plate washing material or the plate and the roller structure.

Referring to FIG. 4, in this embodiment, the cooperative transmission member 32 includes a first cooperative transmission roller 321, a second cooperative transmission roller 322, a sixth cooperative transmission roller 323 and a seventh cooperative transmission roller 324. Both ends of the first cooperative transmission roller 321, the second cooperative transmission roller 322, the sixth cooperative transmission roller 323 and the seventh cooperative transmission roller 324 are installed on the skeleton structure through roller shaft support structures. The first cooperative transmission roller 321, the second cooperative transmission roller 322, the sixth cooperative transmission roller 323 and the seventh cooperative transmission roller 324 can all rotate under a certain pulling force; in this embodiment, the exterior of the sixth cooperative transmission roller 323 is covered with a soft material, but of course, in other embodiments, it may not be covered with a soft material.

In this embodiment, the tensioning member 31 includes a driving part 132, a tensioning part and a clamping and winding part.

Among them, the driving part 132 includes a motor and a synchronous commutator 311. In this embodiment, the driving part 132 can be used to drive the tensioning part to displace in the horizontal direction so that the plate washing material wound on it can abut against the plate transmitted by the plate transmission part 1.

Specifically, there are two synchronous commutators 311, which are symmetrically installed on the inner side wall of the skeleton structure respectively. The two synchronous commutators 311 are connected and assembled to achieve synchronous rotation during use. The motor is assembled with the synchronous commutator 311 and installed on the skeleton structure.

Referring to FIG. 4, at the same time, a tensioning part is also arranged on the skeleton structure. The tensioning part includes a slideway 312 located on the inner side wall of the skeleton structure and a displacement seat 313 slidably connected to the slideway 312. Among them, a lead screw driving module 314 is assembled between the displacement seat 313 and the synchronous commutator 311, so that after the motor is started, the synchronous commutator 311 and the lead screw driving module 314 are driven to act, thereby driving the displacement seat 313 to displace along the slideway 312.

In this embodiment, a clamping and winding part is also rotatably arranged between the two displacement seats 313. In this embodiment, the clamping and winding part can be used to maximize the contact area between the plate washing material and the tensioning part, at least for flattening the plate washing material before plate washing, and increasing the winding stroke, so that the plate washing material can achieve a flattening effect during the dynamic tensioning process.

Referring to FIG. 4, among them, the clamping and winding part includes a third clamping transmission roller 315, a fourth heating transmission roller 316 and a fifth clamping transmission roller 317. Among them, the fourth heating transmission roller 316 is used to push the plate washing material towards the plate transmission part 1, so that the plate can abut against the plate washing material wound on the fourth heating transmission roller 316, so that the plate can be adhered by the plate washing material. The third clamping transmission roller 315 and the fifth clamping transmission roller 317 are horizontally symmetrically arranged in the vertical direction on the side of the fourth heating transmission roller 316 away from the plate transmission part 1. Under the guiding, clamping and abutting of the third clamping transmission roller 315 and the fifth clamping transmission roller 317, the contact area between the plate washing material and the fourth heating transmission roller 316 can be maximized, thereby improving the adhesion of the plate and maintaining a certain temperature; the movement of the displacement seat 313 can drive the third clamping transmission roller 315, the fourth heating transmission roller 316 and the fifth clamping transmission roller 317 to move synchronously. During the movement of the displacement seat 313, since the third clamping transmission roller 315, the fourth heating transmission roller 316 and the fifth clamping transmission roller 317 all generate displacement distances, the tension of the plate washing material wound on them can be adjusted according to the corresponding requirements; in this embodiment, the outer surfaces of the rollers of the clamping part are all covered with soft materials, specifically, the exteriors of the third clamping transmission roller 315, the fourth heating transmission roller 316 and the fifth clamping transmission roller 317 are all covered with soft materials, but of course, in other embodiments, they may not be covered with soft materials.

In this embodiment, the fourth heating transmission roller 316 is provided with a heating tube inside. During operation, the heating tube can heat the fourth heating transmission roller 316 itself, so that the fourth heating transmission roller 316 itself can have a certain temperature, and thus the non-woven fabric wound on it can also have a certain temperature, effectively improving.

Referring to FIG. 4, in this embodiment, the self-suspending member 33 includes an eighth self-suspending sliding roller 331, a ninth self-suspending sliding roller 332 and a tenth self-suspending sliding roller 333. The eighth self-suspending sliding roller 331, the ninth self-suspending sliding roller 332 and the tenth self-suspending sliding roller 333 are all installed on the inner side wall of the skeleton structure. Specifically, the eighth self-suspending sliding roller 331, the ninth self-suspending sliding roller 332 and the tenth self-suspending sliding roller 333 all have self-rotation capabilities. Moreover, the outer surface of the self-suspending member 33 is made of a soft material, that is, the surfaces of the eighth self-suspending sliding roller 331, the ninth self-suspending sliding roller 332 and the tenth self-suspending sliding roller 333 are all covered with soft materials such as rubber and silica gel, so that the eighth self-suspending sliding roller 331, the ninth self-suspending sliding roller 332 and the tenth self-suspending sliding roller 333 all have a good effect of guiding the non-woven fabric material.

In addition, a first sliding groove 334 is provided for the eighth self-suspending sliding roller 331 inside the skeleton structure. Since the eighth self-suspending sliding roller 331 has self-rotation capability, the two roller shaft ends of the eighth self-suspending sliding roller 331 are slidably arranged in the grooves of the two first sliding grooves 334 and abut against the second cooperative transmission roller 322, so that when the second cooperative transmission roller 322 is pulled by the non-woven fabric to rotate, the eighth self-suspending sliding roller 331 can also rotate along with it and press the non-woven fabric so that the non-woven fabric can be tightly pressed on the second cooperative transmission roller 322; correspondingly, a second sliding groove 335 is provided for the ninth self-suspending sliding roller 332 on the two displacement seats 313. Since the ninth self-suspending sliding roller 332 has self-rotation capability, the two roller shaft ends of the ninth self-suspending sliding roller 332 are slidably arranged in the grooves of the two second sliding grooves 335 and abut against the fourth heating transmission roller 316, so that when the fourth heating transmission roller 316 rotates, the ninth self-suspending sliding roller 332 can also rotate along with it and press the non-woven fabric so that the non-woven fabric can be tightly pressed on the fourth heating transmission roller 316; similarly, a third sliding groove 336 is provided for the tenth self-suspending sliding roller 333 inside the skeleton structure. Since the tenth self-suspending sliding roller 333 has self-rotation capability, the two roller shaft ends of the tenth self-suspending sliding roller 333 are slidably arranged in the grooves of the two third sliding grooves 336 and abut against the first active rotating roller 11, so that when the first active rotating roller 11 rotates with the plate, the eighth self-suspending sliding roller 331 can also rotate along with it and press the plate, so that the plate washing material can better wash the plate during the contact with the plate.

The implementation principle of the multi-axis system of the flexographic printing plate washing equipment in the embodiment of the present disclosure:
Referring to FIG. 4, the material transmission part 2 serves as power to drive the non-woven fabric to wind and transmit. The plate transmission part 1 serves as power to drive the plate, and makes the plate rotate and drive closely attached to the surface of the plate transmission part 1 in a clamped state. After the non-woven fabric is tensioned, pressed and other actions by the cooperative transmission member 32, it is in surface contact with the plate under pressure. Driven by the plate transmission part 1, the surface of the plate abuts against the flowing non-woven fabric multiple times, so that the black film on the plate can finally be adhered to the non-woven fabric, thereby achieving the effect of cleaning the plate without liquid. During this period, during the transmission of the plate washing material, the local temperature of the plate washing material can also be raised and maintained, so as to improve the plate washing effect as much as possible during the transmission of the plate washing material and reduce the excessive consumption of the plate washing material.

The above are all preferred embodiments of the present disclosure. This embodiment is only an explanation of the present disclosure, and is not intended to limit the protection scope of the present disclosure. Therefore: all equivalent changes made according to the structure, shape and principle of the present disclosure should be included in the protection scope of the present disclosure.

## Claims

1. A flexographic printing plate washing apparatus multi-axis system, the plate washing equipment comprising a skeleton structure for supporting the multi-axis system, wherein the multi-axis system comprises:
a plate transmission part (1), installed on the skeleton structure and configured for driving a plate to rotate;
a material transmission part (2), installed on the skeleton structure and configured for driving a plate washing material to rotate;
the plate transmission part (1) and the material transmission part (2) cooperate synergistically during a transmission of the plate and the plate washing material, and enable a side surface of the plate washing material abuts against a surface of the plate and adhere to a black film on the surface of the plate.

2. The multi-axis system according to claim 1, further comprising a shaft coordination assembly (3) installed on the skeleton structure, wherein the shaft coordination assembly (3) is configured for winding the plate washing material.

3. The multi-axis system of flexographic plate washing equipment according to claim 2, wherein
the shaft coordination assembly (3) comprises a tensioning member (31) configured for tensioning the plate washing material during use.

4. The multi-axis system of flexographic plate washing equipment according to claim 2, wherein
the shaft coordination assembly (3) further comprises a cooperative transmission member (32) configured for cooperatively transmitting the plate washing material during use;
the cooperative transmission member (32) comprises a first cooperative transmission roller (321), a second cooperative transmission roller (322), a sixth cooperative transmission roller (323) and a seventh cooperative transmission roller (324) that are respectively installed on the skeleton structure;
an exterior of the sixth cooperative transmission roller (323) is covered with a soft material;
and/or,
the exterior of the sixth cooperative transmission roller (323) is not covered with a soft material.

5. The multi-axis system according to claim 2, wherein
the shaft coordination assembly (3) further comprises a self-suspending member (33) configured for flattening the plate washing material or the plate during use.

6. The multi-axis system according to claim 5, wherein an outer surface of the self-suspending member (33) is made of a soft material.

7. The multi-axis system of flexographic plate washing equipment according to claim 3, wherein
the tensioning member (31) comprises a driving part (132), a tensioning part and a clamping and winding part, the driving part (132) is assembled with the tensioning part, the driving part (132) is configured for driving the tensioning part to displace in a horizontal direction so that the plate washing material wound on it abuts against the plate transmitted by the plate transmission part (1), and the clamping and winding part is configured for maximizing a contact area between the plate washing material and the tensioning part to flatten the plate washing material before plate washing;
the clamping and winding part comprises a third clamping transmission roller (315), a fourth heating transmission roller (316) and a fifth clamping transmission roller (317);
the third clamping transmission roller (315) and the fifth clamping transmission roller (317) are arranged on a side of the fourth heating transmission roller (316) away from the plate transmission part (1);
exteriors of the third clamping transmission roller (315), the fourth heating transmission roller (316) and the fifth clamping transmission roller (317) are respectively covered with a soft material;
and/or,
the exteriors of the third clamping transmission roller (315), the fourth heating transmission roller (316) and the fifth clamping transmission roller (317) are respectively not covered with a soft material.

8. The multi-axis system according to claim 1, wherein the material transmission part (2) comprises an outer surface dimension expansion structure.

9. The multi-axis system according to claim 1, wherein the plate transmission part (1) comprises a clamping structure (13) configured for clamping the plate.

10. The multi-axis system according to claim 1, wherein an outer surface of the plate transmission part (1) is made of a soft material.
